# DEMANDE DE BREVET EUROPEEN

(11) **EP 4 797 534 A1**
(43) Date de publication de la demande: **26.08.2026**
(21) Numéro de dépôt: 26160336.9
(22) Date de dépôt: 24.02.2026
(51) Int. Cl.: H03K 5/135, H03K 7/06, H03C 3/06

(54) **MODULATEUR DE FRÉQUENCE NUMÉRIQUE POLAIRE**

(30) Priorité: 25.02.2025 FR 2501920
(71) Demandeur: Commissariat à l'Energie Atomique et aux Energies Alternatives, 75015 Paris (FR)
(72) Inventeur: LACHARTRE, David, 38054 Grenoble Cedex 9 (FR)
(74) Mandataire: Germain Maureau

(57) **Abrégé**

Modulateur 10 comprenant :
- Au moins deux canaux (A, B, C) disposés en parallèle, chaque canal (A, B, C) recevant respectivement en entrée un signal d'horloge de canal (clkin_A, clkin_B, clkin_C), chaque canal (A, B, C) étant apte à retarder le signal d'horloge de canal (clkin_A, clkin_B, clkin_C) afin de générer un signal de canal modulé (clkout_A, clkout_B, clkout_C) en fonction de données de commande de retard de canal (del_A, del_B, del_C);
- Un circuit logique d'entrée (11) recevant en entrée un signal d'horloge maître (clk) ainsi que des échantillons de fréquence normalisés (freq), et apte à générer les signaux d'horloge de canal (clkin_A, clkin_B, clkin_C) et les données de commande de retard de canal (del_A, del_B, del_C) ;
- Un circuit logique de sortie (12) recevant en entrée chaque signal de canal modulé (clkout_A, clkout_B, clkout_C) et apte à générer un signal de sortie modulé en fréquence (dout) issu de leur combinaison.

## Description

### Domaine technique

La présente invention, qui appartient au domaine du traitement de signal, concerne en particulier la transmission de données numériques sur un canal de communication via une modulation angulaire.

Précisément, la présente invention porte sur un modulateur de fréquence numérique polaire pouvant par exemple être avantageusement mis en oeuvre dans tout émetteur radio transmettant des données numériques, ou encore dans des synthétiseurs de fréquence de grande précision.

La présente demande porte également sur un procédé de modulation mis en oeuvre par le modulateur de fréquence numérique polaire de l'invention.

### Préambule

Les transmissions de données numérique impliquant une modulation angulaire consistent de manière générale à transmettre des séries de bits successives représentées par l'émetteur sous forme de symboles (ou symboles de phase) auxquels sont associées respectivement des valeurs ponctuelles de phases (cas de la modulation de phase) ou des variations de phase (cas de la modulation de fréquence) destinées à générer un signal modulé à transmettre à partir d'un signal périodique régulier (ci-après également désigné par porteuse) de fréquence fixe F_{c} (dite fréquence porteuse).

Il est établi que la modulation de phase cartésienne, basée sur la représentation cartésienne de la phase sur le cercle trigonométrique et sur la génération de signaux analogiques, présente plusieurs inconvénients, certains desquels étant d'ailleurs rappelés dans la demande de brevet français publiée sous le numéro FR3100404 A1.

En tant qu'alternative à la modulation de phase cartésienne, la modulation de phase polaire, qui consiste à moduler directement la phase (sans passer par sa représentation cartésienne sur le cercle trigonométrique) de la porteuse, offre différents avantages, dont notamment le fait de reposer principalement sur des blocs logiques et donc sur des signaux logiques binaires.

Par exemple, tant la porteuse que le signal modulé peuvent être, dans le cas de la modulation de phase polaire, des signaux logiques binaires qui sont par nature plus faciles à traiter que les signaux analogiques sur lesquels se base la modulation de phase cartésienne.

Parmi les techniques de modulation de phase polaire existantes, celle consistant à appliquer les symboles de phase directement sur un unique signal d'horloge (jouant le rôle de porteuse) au moyen d'un bloc retard variable (circuit logique) est intéressante en ce qu'elle établit la relation linéaire suivante entre le retard Tᵣ appliqué au signal d'horloge et le déphasage φ : ${T}_{r} = φ / \left(2π.{F}_{c}\right) .$

Cependant, appliquer chaque symbole de phase à la porteuse sur l'intégralité de la période symbole T_{sy}, (T_{sy} = 1/F_{sy}, F_{sy} étant la fréquence symbole représentant le nombre de symboles transmis par seconde) entraine malheureusement des transitions de phase trop abruptes entre deux symboles adjacents et donc la génération de fréquences élevées supérieures aux fréquences théoriquement disponibles pour l'émetteur.

Aussi convient-il d'échantillonner la phase à une fréquence d'échantillonnage Fₛ au moins deux fois supérieure à la fréquence symbole (Fₛ > 2.F_{sy}) afin d'assurer des transitions douces et progressives entre les symboles et donc éviter l'émission de fréquences parasites élevées.

En outre, de par la nature binaire de la porteuse (signal d'horloge), les échantillons de phase ne s'appliquent à l'horloge porteuse que pendant les transitions entre les niveaux logiques haut et bas (et inversement), c'est-à-dire lors des fronts descendants et des fronts montants de l'horloge porteuse, et une désynchronisation entre la fréquence d'échantillonnage Fₛ et la fréquence porteuse F_{c} peut donc entrainer des décalages aléatoires et difficilement prévisibles entre l'application des échantillons de phase et leur action effective sur l'horloge porteuse.

Pour éviter la survenance de ces décalage indésirables, il est nécessaire que la fréquence d'échantillonnage Fₛ soit synchrone de la fréquence porteuse F_{c}. En pratique, Fₛ doit être au moins égale à F_{c} et une valeur optimale de Fₛ correspond notamment à 2.F_{c}.

En règle générale, les modulateurs numériques existants permettent des modulations de phase efficaces tant que les échantillons de phase à appliquer ne dépassent pas 2π (c'est-à-dire 360°) et que la phase ne présente pas de variations trop brutales d'un échantillon au suivant.

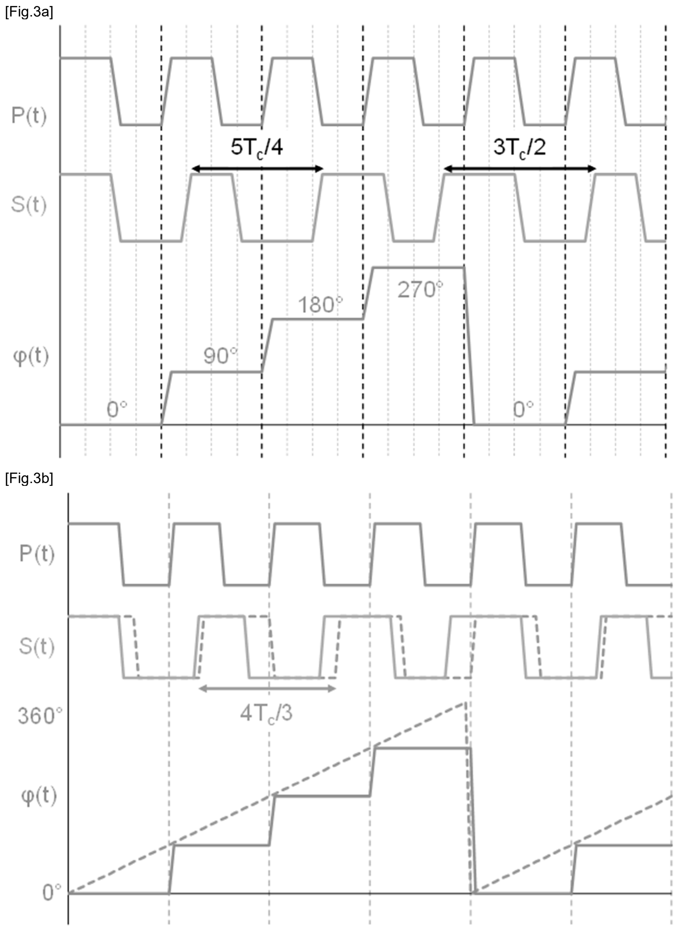

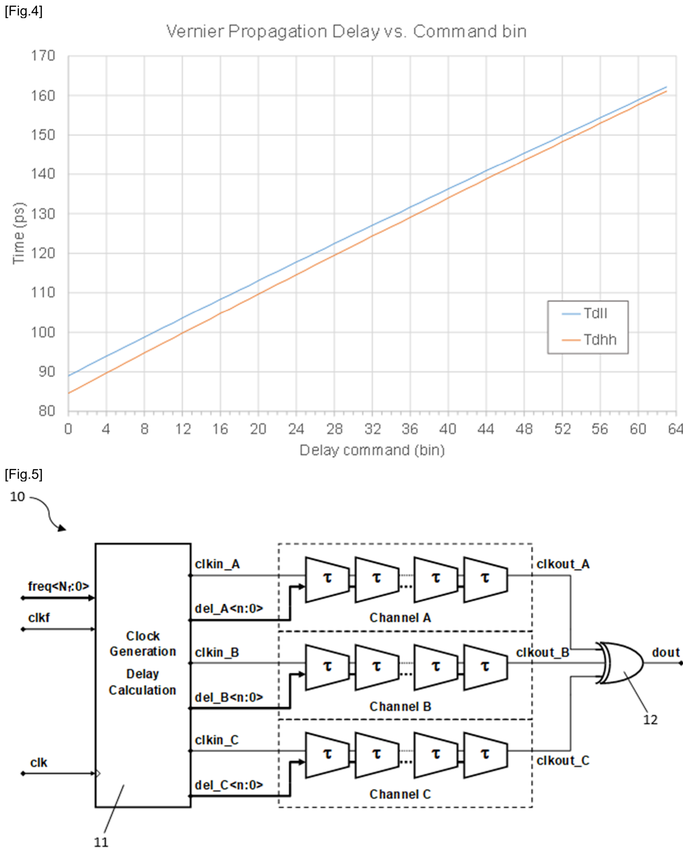

Ceci étant dit et comme on le verra sur les figures 3 et 4, certains modulateurs existants génèrent un signal modulé de fréquence erronée à partir du moment où les échantillons de phase sortent de l'intervalle [0 ; 2π[ et/ou lorsque ont lieu des sauts de phase importants et non lissés par un échantillonnage.

De telles erreurs sur la fréquence du signal modulé entrainent forcément sur ce signal un décalage temporel incohérent et donc des erreurs dans les informations de phase transportées, et diminuent donc drastiquement la qualité de la transmission sur le canal de communication.

Or, la modulation de fréquence, qui est basée non pas sur des valeurs ponctuelles de phase mais sur des variations de phase, ne se limite pas par nature à des échantillons de phase dont la valeur serait comprise dans l'intervalle [0 ; 2π[ .

De plus, fournir un modulateur supportant des variations brutales de phase permet évidemment d'augmenter la fréquence symbole F_{sy} et donc *in fine* le débit binaire pouvant être atteint par l'émetteur équipé d'un tel modulateur.

Il existe donc un besoin de fournir un modulateur numérique polaire qui soit compatible avec la modulation de fréquence et permette d'atteindre des débits binaires élevés en émission.

### Résumé de l'invention

L'invention vise à remédier à tout ou partie des inconvénients précités.

En particulier, l'invention porte, selon un premier aspect, sur un modulateur comprenant :
- Au moins deux canaux disposés en parallèle, chaque canal recevant respectivement en entrée un signal d'horloge de canal, chaque canal étant apte à retarder les fronts montants et/ou descendants du signal d'horloge de canal afin de générer un signal de canal modulé en fonction de données de commande de retard de canal respectivement ;
- Un circuit logique d'entrée recevant en entrée un signal d'horloge maître de fréquence ainsi que des échantillons de fréquence, et apte à générer les signaux d'horloge de canal à partir du signal d'horloge maître, et générer les données de commande de retard de canal en fonction des échantillons de fréquence normalisés freq ;
- Un circuit logique de sortie recevant en entrée chaque signal de canal modulé et apte à générer un signal de sortie modulé en fréquence issu de la combinaison des signaux de canal modulés.

Selon une possibilité, chacun desdits canaux comprend au moins une cellule retard apte à retarder les fronts montants et/ou les fronts descendants du signal d'horloge de canal reçu en entrée.

Le fait de disposer en parallèle plusieurs canaux dotés d'au moins une cellule retard et de combiner en sortie les signaux de canal modulés permet de distribuer les fronts montants et descendants entre les canaux, et donc entre les cellules retard, et ainsi de multiplier la fréquence du signal de sortie modulé par autant qu'il y a de canaux en parallèle, tout en réduisant la fréquence de chaque signal d'horloge de canal.

L'invention permet donc d'atteindre, de manière cohérente, des fréquences porteuses élevées sans pour autant que la fréquence du signal d'horloge de canal appliqué en entrée de chaque canal, et donc retardé par l'au moins une cellule retard, soit élevée.

Selon une possibilité, les cellules retard comprises dans les canaux parallèles du modulateur sont toutes identiques.

Selon une possibilité, chacune des cellules retard comprend au moins un condensateur.

Selon une possibilité, l'au moins un condensateur est relié à un élément de commutation, par exemple un interrupteur ou un commutateur.

Selon une autre possibilité, chacune des cellules retard comprend au moins un transistor, et par exemple au moins un transistor MOS.

Selon une possibilité, le modulateur est un modulateur de fréquence numérique polaire qui agit directement sur le signal d'horloge porteuse, qui est un signal numérique binaire pouvant présenter deux niveaux : un niveau haut, et un niveau bas, et qui présente des transitions entre lesdits niveaux sous la forme de fronts montants (pour passer du niveau bas au niveau haut) et de fronts descendants (pour passer du niveau haut au niveau bas).

Selon une possibilité, le signal d'horloge maître présente une fréquence dont la valeur correspond à deux fois celle de la fréquence porteuse du modulateur.

Selon une possibilité, les échantillons de fréquence sont fournis au circuit logique d'entrée au rythme d'un signal d'horloge d'échantillonnage dont la fréquence est inférieure à la fréquence porteuse du modulateur.

Selon un mode de réalisation, le nombre de canaux est impair.

Selon une possibilité, le modulateur comprend au moins trois canaux disposés en parallèle.

Selon un mode de réalisation, le circuit logique de sortie comprend une porte logique « ou exclusif ».

Selon une possibilité, la porte logique génère en sortie le signal de sortie modulé en réalisant la combinaison de tous les fronts montants et descendants de chaque signal de canal modulé.

Selon un mode de réalisation, chaque canal comprend au moins deux cellules retard identiques montées en série et aptes à retarder les fronts montants et/ou descendants du signal d'horloge de canal en fonction de données de commande de retard de cellule.

Le fait de cascader plusieurs cellules retard sur chacun des canaux permet d'augmenter la dynamique de modulation, c'est-à-dire d'augmenter le delta de retard (c'est-à-dire l'écart entre le retard maximum et le retard minimum appliqué par le canal) produit par l'ensemble des cellules retard. En d'autres termes, cela permet d'augmenter les retards possibles, les delta de phase et donc les fréquences de modulation accessibles au modulateur.

Selon une possibilité, les cellules retard d'un même canal sont identiques.

Selon une possibilité, toutes les cellules retard du modulateur sont identiques.

Selon un mode de réalisation, le nombre R de cellules retard par canal est une puissance de 2.

Selon un mode de réalisation, le nombre R de cellules retard par canal vérifie : $R > \frac{1}{{F}_{clk} \left({T}_{dmax}-{T}_{dmin}\right)}$ où T_{dmin} et T_{dmax} sont respectivement le retard minimum et le retard maximum applicable par chacune des cellules retard.

Selon un mode de réalisation, chaque cellule retard d'un même canal est associé à un unique bloc de calcul numérique apte à générer la donnée de commande de retard de cellule destinée à la cellule retard à laquelle il est associé en fonction des données de commande de retard de canal.

Selon une possibilité, chaque bloc de calcul numérique génère la donnée de commande de retard de cellule destinée à la cellule retard à laquelle il est associée au moyen d'un échantillonnage du signal de commande de retard de canal qu'il reçoit en entrée, lequel comprend les données de commande de retard de canal.

Selon une possibilité, ledit échantillonnage est réalisé par le biais du signal d'horloge de canal retardé par ladite cellule retard.

Selon ces dispositions, les données de commande de retard de cellule reçues par une cellule retard d'un canal donné sont distinctes des données de commande de retard de cellule reçues par chacune des autres cellules retard de ce même canal.

Cela permet d'augmenter la fréquence maximale du signal d'horloge de canal, car le retard maximum applicable par la série des cellules du canal n'est plus une contrainte agissant sur ladite fréquence.

Selon un mode de réalisation, le circuit logique d'entrée comprend un circuit de correction de fréquence apte à mettre en œuvre une fonction de correction des échantillons de fréquence normalisés freq de manière à obtenir des échantillons de fréquence corrigés telle que : $freq ′ = \frac{- freq {.2}^{{N}_{f}}}{freq + {2}^{{N}_{f}}}$

Avantageusement, ce circuit de correction de fréquence permet de corriger les sauts de phase appliqués par le modulateur en passant du domaine temporel au domaine fréquentiel du signal modulé généré en sortie du modulateur.

Selon un mode de réalisation, le circuit logique d'entrée comprend autant de canaux de calcul que de canaux compris par le modulateur, chaque canal de calcul étant associé à un desdits canaux et générant le signal d'horloge de canal et la donnée de commande de retard de canal destinés au canal lui étant associé.

Selon un mode de réalisation, chaque canal de calcul comprend un premier sous-canal dédié au calcul du retard appliqué aux fronts montants du signal d'horloge maître et un deuxième sous-canal dédié au calcul du retard appliqué aux fronts descendants du signal d'horloge maître.

Selon un mode de réalisation, le modulateur comprend en outre un canal de calibration.

Selon une possibilité, le modulateur comprend un unique canal de calibration destiné à réaliser la calibration des retards appliqués par chacun des canaux du modulateur.

Selon un deuxième aspect, l'invention porte sur un procédé de modulation polaire de fréquence mis en œuvre par un modulateur tel que décrit ci-dessus, le procédé comprenant :
- Une étape de génération, par le circuit logique d'entrée du modulateur, de signaux d'horloge de canal à partir d'un signal d'horloge maître reçu en entrée du circuit logique d'entrée du modulateur ;
- Une étape de génération des données de commande de retard de canal, par le circuit logique d'entrée du modulateur, en fonction des échantillons de fréquence normalisés freq reçus en entrée du circuit logique d'entrée du modulateur ;
- Une étape de génération des signaux de canal modulé à partir des signaux d'horloge de canal et en fonction des données de commande de retard de canal ;
- Une étape de génération du signal de sortie modulé, par le circuit logique de sortie du modulateur, en combinant les signaux de canal modulés.

Ainsi, le modulateur permet de moduler sur une fréquence porteuse, une fréquence échantillonnée fᵢ telle que freq = (fᵢ/F_{c})*2^{Nf} et N_{f}+1 le nombre de bits des échantillons de modulation de fréquence normalisés freq.

Selon une possibilité, la fréquence porteuse correspond à la moitié de la fréquence du signal d'horloge maître.

Selon une possibilité, les échantillons de fréquence sont reçus au rythme d'un signal d'horloge d'échantillonnage de fréquence inférieure à la fréquence porteuse.

### Brève description des figures

L'invention sera mieux comprise, et ses principes et avantages mieux appréhendés et mis en lumière, à la lecture de la description détaillée ci-dessous, faite en référence aux figures parmi lesquelles :
[Fig.1] est un chronogramme représentant un signal modulé S(t) obtenu via une modulation de phase appliquée à un signal d'horloge P(t).
[Fig.2] est un chronogramme représentant un signal modulé S(t) obtenu via une modulation de phase avec échantillonnage appliquée à un signal d'horloge P(t).
[Fig.3a] et [Fig.3b] illustre respectivement l'erreur sur la fréquence du signal modulé S(t) et le décalage introduit par l'échantillonnage de la phase par rapport à un signal modulé et non échantillonné.
[Fig.4] est un diagramme représentant deux courbes illustrant le retard commandé introduit par une cellule retard sur respectivement un front montant et un front descendant d'horloge, en fonction de la commande binaire de la cellule.
[Fig.5] est un schéma de principe d'un modulateur conforme à un premier mode de réalisation de l'invention.
[Fig.6] est un schéma représentant la mise en cascade série des cellules retard dans un des canaux du modulateur de la figure 5.
[Fig.7] est un schéma détaillé de l'association d'une cellule retard à un bloc logique local.
[Fig.8a] est un chronogramme illustrant le principe de fonctionnement du modulateur de la figure 5 appliquant une modulation de fréquence fixe de - 500MHz sur une fréquence porteuse F_{c} = 1GHz.
[Fig.8b] est un chronogramme illustrant le principe de fonctionnement du modulateur de la figure 5 appliquant une modulation de fréquence fixe de + 500MHz sur une fréquence porteuse F_{c} = 1GHz.
[Fig.8c] est un chronogramme illustrant la modulation de fréquence selon l'invention.
[Fig.8d] est une courbe qui représente la fonction de correction de fréquence normalisée par F_{c}.
[Fig.9] est un schéma d'un premier exemple de réalisation du bloc de génération d'horloge et de calcul de retard du modulateur de la figure 5.
[Fig.10a] est un schéma d'un deuxième exemple de réalisation du bloc de génération d'horloge et de calcul de retard du modulateur de la figure 5, avec prise en compte du modulo.
[Fig.10b] est un schéma d'un sous-canal de génération d'horloge et calcul de retard du bloc de la figure 10a.
[Fig.11a] est un schéma de principe d'un modulateur conforme à un deuxième mode de réalisation de l'invention, avec calibration.
[Fig.11b] représente une table de vérité d'un comparateur de phase mis en oeuvre au sein du modulateur de la figure 11a.
[Fig.12a] à [Fig.12c] sont trois exemples de réalisation d'une cellule retard utilisée dans les modulateurs des figures 5 et 11.
[Fig.13] est un exemple de réalisation d'un décodeur 3 bits vers 7 bits thermométrique utilisé dans la cellule retard la figure 12a.
[Fig.14] est un chronogramme d'un signal généré par un synthétiseur de fréquence dit « chirp ».
[Fig.15] est un schéma de principe d'un synthétiseur de fréquence « chirp » mettant en œuvre le modulateur de l'invention.
[Fig.16] représente un circuit logique apte à réaliser la division d'un signal d'horloge par un nombre entier.
[Fig.17] représente un circuit de bascules D actif sur les deux fronts d'horloge.

### Description détaillée

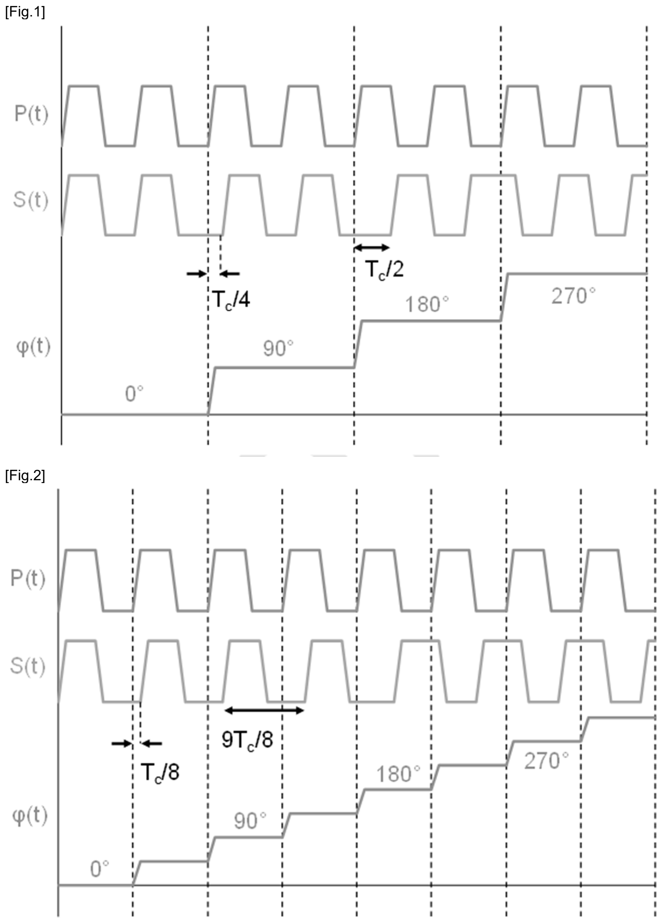

Les figures 1 à 4 permettent dans un premier temps de mieux comprendre les principes de la modulation de phase polaire, ainsi que les inconvénients et limitations que connaissent les modulateurs existants.

Sur la figure 1 est représenté un signal modulé S(t) obtenu via une modulation de phase appliquée à un signal d'horloge porteuse P(t) de fréquence F_{c}. La phase φ(t) correspond à une série de données numériques sous la forme d'une suite de symboles de phases variables en fonction du temps, lesquels sont successivement et directement appliqués au signal d'horloge porteuse P(t) avec une fréquence symbole F_{sy}.

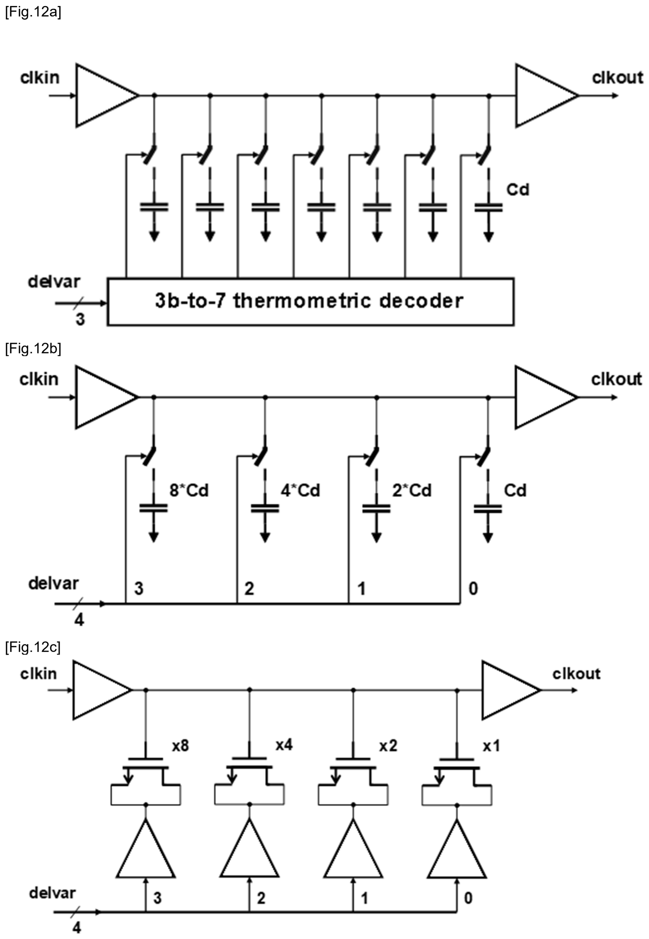

Les valeurs de phase variable sont appliquées au signal d'horloge porteuse P(t) au moyen d'un bloc retard variable numérique, comprenant par exemple au moins une cellule retard telle que représentée à la figure 12a, apte à retarder les fronts montants du signal P(t) d'un retard variable Tᵣ(t) = φ(t)/(2π.F_{c}).

Un tel bloc retard variable numérique est de manière générale un circuit logique capable de transmettre un signal numérique reçu en entrée avec un retard variable correspondant à un temps de propagation dans le circuit logique du signal numérique reçu en entrée, ledit temps de propagation variant avec la charge capacitive en sortie du circuit logique.

Par défaut, chaque symbole de phase est appliqué à l'horloge porteuse pendant toute la période symbole : T_{sy} = 1/F_{sy}, ce qui fait que lorsque le symbole change, la phase appliquée à l'horloge porteuse change brutalement sans transition, ce qui entraine la génération d'un signal modulé de très grande fréquence.

Afin d'éviter des transitions de phase trop abrupts entre les symboles de phase consécutifs et donc la génération de fréquences trop élevées (et non supportées ni prévues par le modulateur), il est souhaitable d'échantillonner la phase φ(t) à une fréquence d'échantillonnage Fₛ au moins deux fois supérieure à la fréquence symbole F_{sy} : Fₛ > 2.F_{sy}, afin d'obtenir des échantillons de phase supplémentaire à appliquer à l'horloge porteuse.

De plus, afin d'éviter la survenance de décalages aléatoires et imprévisibles entre l'application des échantillons de phase et leur action effective sur l'horloge porteuse et donc la génération d'un bruit intempestif par le modulateur, il est impératif que la fréquence d'échantillonnage Fₛ soit synchronisée sur la fréquence porteuse F_{c}, et plus particulièrement que la fréquence d'échantillonnage Fₛ soit par exemple égale à la fréquence porteuse F_{c} (comme cela est représenté à la figure 2), ou encore que la fréquence d'échantillonnage Fₛ soit égale à 2.F_{c} (impliquant que chaque front montant ou descendant de l'horloge porteuse soit retardé par un nouvel échantillon de phase).

Ainsi, la figure 2 représente un signal modulé S(t) obtenu via une modulation de phase appliquée à un signal d'horloge porteuse P(t) de fréquence F_{c}, au moyen d'un échantillonnage de la phase φ(t) à une fréquence d'échantillonnage équivalente à la fréquence porteuse Fₛ = F_{c} introduisant donc un échantillon de phase intermédiaire entre deux symboles de phase successifs.

Un tel échantillonnage de la phase, en lissant les transitions de phase, permet donc d'obtenir en sortie un signal modulé cohérent lorsque les valeurs des échantillons de phase restent cantonnées à l'intervalle [0;2π[.

Il n'en reste pas moins que, comme on le verra ci-après, des difficultés supplémentaires surviennent lorsque la phase, bien qu'échantillonnée, dépasse la dynamique allant de 0 à 2π et/ou connait des variations importantes (malgré l'échantillonnage).

Ainsi et comme le montrent les figures 3a et 3b, lorsque la phase φ(t) atteint 2π, il est nécessaire d'appliquer un modulo 2π pour revenir à une phase nulle (symbole de phase correspondant à 0°) et il est manifeste qu'un problème survient dans la mesure où aucun front montant de l'horloge P(t) n'est transmis en sortie sur la période symbole correspondante. En d'autres termes, le front montant de P(t) qui a subi le modulo 2π n'a pas été propagé au signal modulé S(t) au passage à la phase 0°.

De plus et si l'on considère un cycle complet de la phase φ(t) de 0 à 2π s'étendant sur une période temporelle équivalente à 4.T_{c} (T_{c} = 1/F_{c}), le signal modulé S(t) présente des incohérences en termes de fréquence, et l'on constate en effet que S(t) ne réalise alors sur cette période temporelle équivalente à 4.T_{c} que trois périodes : deux premières périodes équivalentes à 5.T_{c} / 4 (du fait des retards équivalents à Tc/4 qui allongent la période de S(t) par rapport à celle de P(t)) et une troisième et dernière période équivalente à 3.T_{c} / 2 (puisqu'un cycle entier équivaut à 4.T_{c} = 5.T_{c} / 4 + 5.T_{c} / 4 + 3.T_{c} / 2).

Or, la modulation de phase illustrée sur la figure 3a met en oeuvre des sauts de phase Δφ constants et équivalents à π/2 entre deux symboles consécutifs, et chacun de ces sauts de phase Δφ constants correspond théoriquement à une fréquence Fᵢ = Δφ/2π.T_{c} = F_{c}/4 se soustrayant à la fréquence porteuse F_{c} de manière à obtenir la fréquence théorique du signal modulé S(t), soit F_{c} - Fᵢ = 3.F_{c} / 4.

Cette fréquence théorique 3.F_{c} / 4 du signal modulé S(t) équivaut à une période égale à 4.T_{c} / 3 qui ne correspond en fait à aucune des périodes du signal S(t) pouvant être observées sur la figure 3a (pour rappel, 5.T_{c} / 4 et 3.T_{c} / 2). Cette incohérence est due à un phénomène de glissement entre la période des échantillons de phase et la période du signal S(t) généré en sortie du modulateur.

La génération d'un signal modulé S(t) avec des fréquences erronées empêche notamment la bonne gestion, par le modulateur, du modulo lorsque la phase revient à 0 après avoir atteint 2π, ce qui aboutit évidemment à des valeurs de phase fausses et donc à des erreurs dans les informations transmises. La figure 3b illustre d'ailleurs bien ce phénomène par comparaison du signal S(t) (en trait continu) de la figure 3a à un signal modulé (en traits pointillés) obtenu via une modulation de phase en temps continu, c'est-à-dire une modulation de phase non-échantillonnée, ce dernier présentant bien une période équivalente à 4.T_{c} / 3 et un front montant synchronisé avec le front montant de l'horloge porteuse P(t) lors du retour à 0°.

Il est connu d'utiliser des cellules retard numériques telles que représentées aux figures 12a à 12c pour retarder un signal numérique reçu en entrée de la cellule, produisant ainsi en sortie un signal numérique retardé sur la base d'une commande binaire de la cellule retard.

De telles cellules retard ne retardent typiquement qu'un front d'horloge à la fois, soit le front montant, soit le front descendant. La figure 4 enseigne respectivement, en fonction de la commande binaire du retard (représentée sur 6 bits), une première courbe représentant la valeur du retard Tdhh appliqué au front montant du signal d'horloge, et une deuxième courbe représentant la valeur du retard Tdll appliqué au front descendant du signal d'horloge.

On relève qu'une telle cellule retard est capable de provoquer des retards sur commande allant d'environ 90 picosecondes (ps) à 160 ps en fonction de la valeur de la commande binaire, soit un delta de retard d'environ 70 ps qui correspond en fait à un delta de phase égal à π puisqu'une cellule retard ne retarde qu'un seul front d'horloge (montant ou descendant) à la fois.

Un delta de phase de 2π correspond donc à un delta de retard d'environ 2*70 ps = 140 ps. En d'autres termes, pour pouvoir moduler sur 2π, la fréquence porteuse doit être au moins égale à F_{c} = 1 / 140 ps, soit 7,14 GHz.

D'un autre côté, le retard appliqué par la cellule retard à un seul front montant/descendant d'horloge par la cellule retard pouvant atteindre 160 ps, deux fronts consécutifs de l'horloge porteuse appliquée à la cellule retard doivent donc être espacés d'au moins 160 ps, En d'autres termes, la période du signal d'horloge porteuse doit être au moins supérieure à 320 ps, et sa fréquence au moins inférieure à 3,125 GHz.

Il découle de ce qui précède qu'une seule cellule retard n'est pas suffisante pour réaliser une modulation de phase entre 0 et 2π, d'autant plus que pour assurer la stabilité de la cellule retard, il est nécessaire que chaque commande de retard appliquée par la cellule soit établie avec un certain temps de prépositionnement sur le front d'horloge à retarder effectivement, ce qui impose une valeur de fréquence porteuse bien inférieure à 3,125 GHz.

En outre, la disposition en série de deux ou plus cellules retard identiques pour retarder le signal d'horloge porteuse aboutirait exactement au même problème, puisque cela reviendrait à augmenter tant le delta de retard correspondant à 2π que la valeur maximale du retard pouvant être appliqué par l'ensemble de cellules retard à chaque front de l'horloge porteuse. Ceci diminue encore la fréquence porteuse possible.

Le modulateur 10 de la figure 5 apporte une solution satisfaisante aux inconvénients décrits ci-dessus. Il s'agit d'un modulateur numérique polaire comprenant des cellules retard identiques τ dont certains exemples de réalisation sont représentés à l'une des figures 12a à 12c.

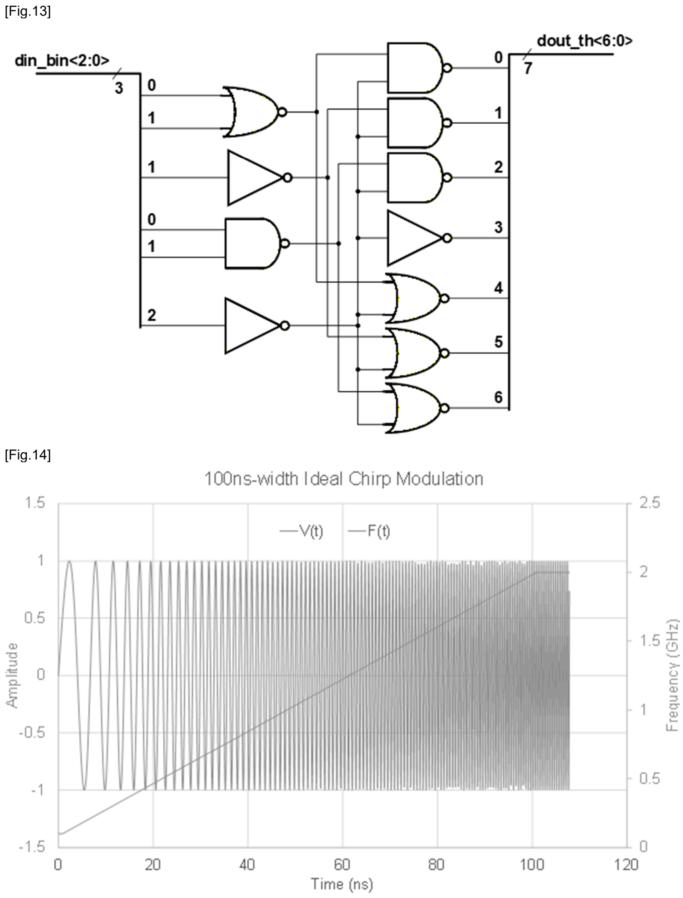

La cellule retard représentée à la figure 12a est une cellule retard numérique (dite cellule de Vernier retard ou cellule de type Vernier) apte à transmettre en sortie un signal clkout retardé par rapport à un signal clkin reçu en entrée et qui se propage au sein de la cellule retard numérique avec un temps de propagation non nul. Une telle cellule retard numérique est commandée par un décodeur 3 bits vers 7 bits thermométrique, représenté à la figure 13 et dont les principes de fonctionnement, connus de l'homme de l'art, ne seront pas décrits plus en détails.

L'utilisation d'un décodeur thermométrique pour commander la cellule retard permet de minimiser les effets dus à la dispersion des valeurs des condensateurs utilisés pour réaliser le retard d'horloge.

La commande fournie par le décodeur thermométrique, en agissant sur la position ouverte ou fermée d'interrupteurs, permet de connecter plus ou moins de condensateurs, reliés en série, à la cellule retard, ce qui aura pour conséquence d'accroitre ou de réduire le temps de propagation du signal clkin au sein de la cellule retard numérique, et donc d'accroitre ou de réduire le retard avec lequel sera généré en sortie le signal clkout.

La figure 12b représente une première variante de réalisation d'une cellule retard numérique de type Vernier, dans laquelle les condensateurs sont regroupés en puissance de 2 et commutés directement par les bits d'une commande binaire.

La figure 12c représente une deuxième variante de réalisation d'une cellule retard numérique dans laquelle les condensateurs sont réalisés au moyen de grilles de transistors MOS. La variation de capacité sur le nœud intermédiaire est obtenu par l'effet varactor des MOS dans lesquels la capacité sur la grille varie en fonction de la polarisation de la source et du drain du transistor.

Pour un transistor NMOS cette capacité augmente en même temps que la tension de source et de drain. Grâce à cet effet, le retard variable est obtenu sans avoir à disposer des interrupteurs au niveau de chaque condensateur. La cellule retard de la figure 12c permet donc également d'obtenir une variation de retard linéaire en fonction de la commande, et présente l'avantage d'être plus compacte que les cellules des figures 12a et 12b faisant appel à des condensateurs.

Le modulateur 10 présente trois canaux A, B, C disposés en parallèle, chacun desdits trois canaux A, B, C comprenant un même nombre de cellules retard identiques τ montées en série.

-Le canal A reçoit en entrée un signal d'horloge de canal clkin_A et étant apte à retarder les fronts montants et/ou les fronts descendants du signal d'horloge de canal clkin_A afin de générer en sortie un signal de canal modulé clkout_A en fonction de données de commande de retard de canal del_A.

-Le canal B reçoit en entrée un signal d'horloge de canal clkin_B et étant apte à retarder les fronts montants et/ou les fronts descendants du signal d'horloge de canal clkin_B afin de générer en sortie un signal de canal modulé clkout_B en fonction de données de commande de retard de canal del_B.

-Le canal C reçoit en entrée un signal d'horloge de canal clkin_C et étant aptes à retarder les fronts montants et/ou les fronts descendants du signal d'horloge de canal clkin_C afin de générer en sortie un signal de canal modulé clkout_C en fonction de données de commande de retard de canal del_C.

Le modulateur 10 comprend un circuit logique d'entrée 11 recevant en entrée un signal d'horloge maître clk de fréquence F_{clk} ainsi que des échantillons de fréquence freq, le circuit logique d'entrée 11 étant respectivement apte à générer en sortie, à partir du signal d'horloge maître clk, le signal d'horloge de canal clkin_A, le signal d'horloge de canal clkin_B et le signal d'horloge de canal clkin_C.

La fréquence F_{clk} minimale du signal d'horloge maître clk est inversement proportionnelle au nombre de canaux disposés en parallèle dans le modulateur. Précisément, la fréquence F_{clk} du signal d'horloge maître reçu en entrée par le modulateur 10 est le double de la fréquence porteuse F_{c}, et ce pour pouvoir cadencer le circuit logique d'entrée 11 sur un seul front.

Le circuit logique d'entrée 11 est également apte à générer, en fonction des échantillons de fréquence freq, les données de commande de canal del_A, del_B, del_C.

Les échantillons de fréquence freq, qui possèdent N_{f}+1 bits, sont fournis au circuit logique d'entrée 11 au rythme d'un signal d'horloge d'échantillonnage clkf de fréquence F_{f} inférieure à la fréquence porteuse F_{c} du modulateur.

Le modulateur 10 comprend également un circuit logique de sortie 12, en l'occurrence une porte logique « ou exclusif », recevant en entrée chaque signal de canal modulé clkout_A, clkout_B, clkout_C, et apte à générer un signal de sortie modulé en fréquence dout issu de la combinaison des signaux de canal modulés clkout_A, clkout_B, clkout_C.

Précisément, la porte logique génère le signal de sortie modulé dout en réalisant la combinaison de tous les fronts montants et descendants desdits signaux de canal modulés clkout_A, clkout_B, clkout_C.

Le canal A comprend plusieurs cellules retard τ identiques disposées en série, chacune étant apte à retarder les fronts montants et/ou descendants du signal d'horloge de canal clkin_A en fonction de données de commande de retard de cellule del. En particulier, le nombre de cellule retard τ disposé sur le canal A est équivalent à une puissance de 2.

Le canal B comprend également plusieurs cellules retard τ identiques disposées en série, chacune étant apte à retarder les fronts montants et/ou descendants du signal d'horloge de canal clkin_B en fonction de données de commande de retard de cellule del. En particulier, le nombre de cellule retard τ disposé sur le canal B est équivalent à une puissance de 2.

Le canal C comprend plusieurs cellules retard τ identiques disposées en série, chacune étant apte à retarder les fronts montants et/ou descendants du signal d'horloge de canal clkin_C en fonction de données de commande de retard de cellule del. En particulier, le nombre de cellule retard τ disposé sur le canal C est équivalent à une puissance de 2.

Les données de commande de retard de canal del_A, del_B, del_C sont des commandes numériques possédant n+1 bits et sont calculées puis fournies aux cellules retard par le circuit logique d'entrée 11 au rythme des signaux d'horloge de canal clkin_A, clkin_B, clkin_C générés à partir du signal d'horloge maître clk de fréquence F_{clk}.

Précisément :
- les données de commande de retard de canal del_A sont fournies au rythme du signal d'horloge de canal clkin_A qui présente des durées entre deux fronts successifs variables ;
- les données de commande de retard de canal del_B sont fournies au rythme du signal d'horloge de canal clkin_B qui présente des durées entre deux fronts successifs variables ;
- les données de commande de retard de canal del_C sont fournies au rythme du signal d'horloge de canal clkin_C qui présente des durées entre deux fronts successifs variables.

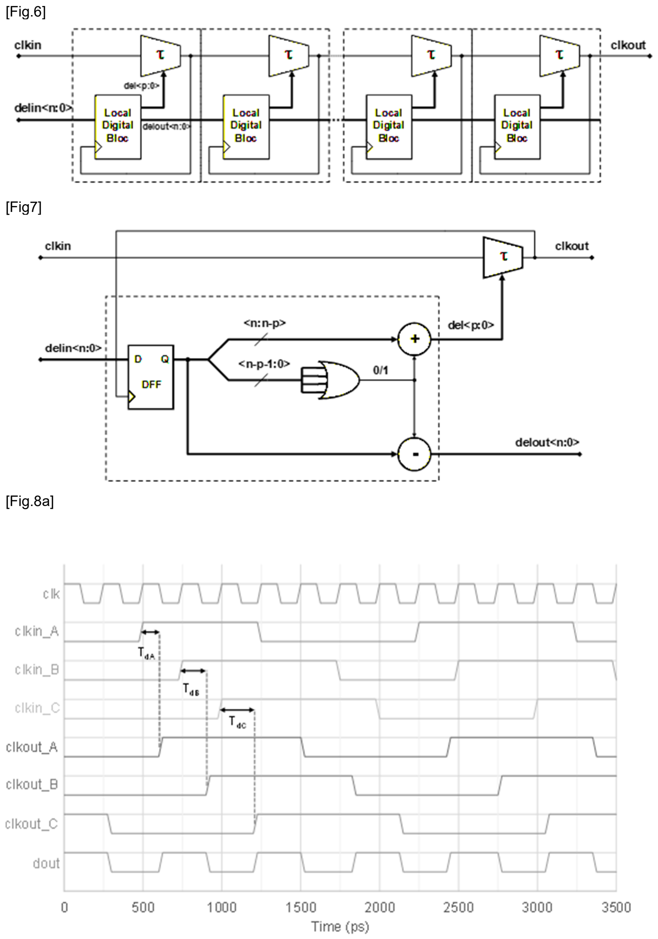

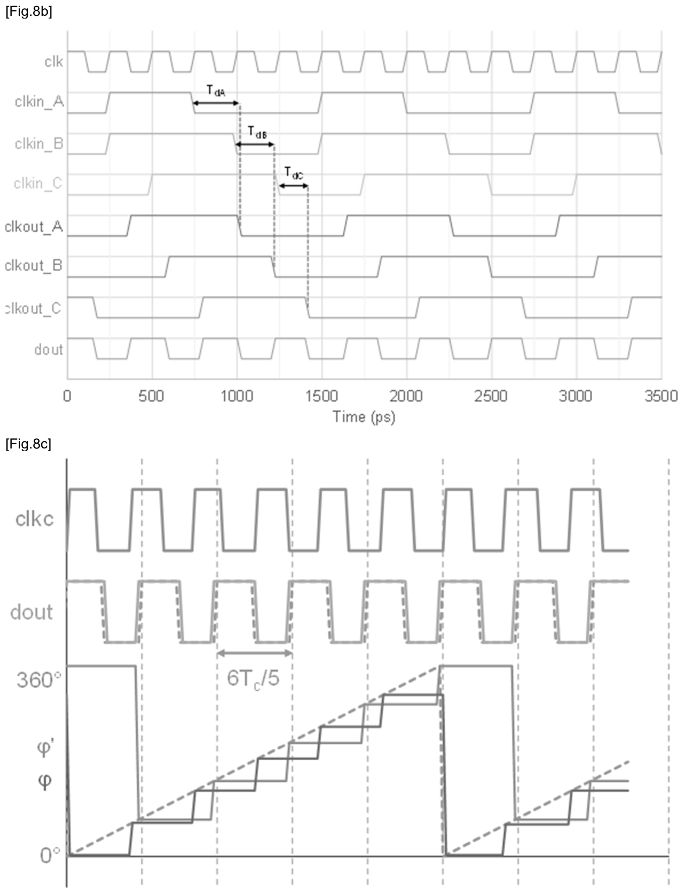

Comme cela est visible sur les figures 8a et 8b, les signaux d'horloge de canal clkin_A, clkin_B, clkin_C sont synchrones des fronts montants du signal d'horloge maître clk et présentent effectivement des durées entre deux fronts variables, c'est-à-dire que ces horloges de canal possèdent des rapports cycliques variables.

Grâce au nombre impair de canaux, l'opération logique réalisée par le circuit logique de sortie 12 a pour conséquence que les fronts montants du signal de sortie modulé dout sont toujours produits par les fronts montants de clkout_A et clkout_C ainsi que par les fronts descendants de clkout_B. On verra ci-après que cela représente également un intérêt en termes de calibration du modulateur.

Réciproquement, les fronts descendants sont produits par les fronts descendants de clkout_A et clkout_C ainsi que les fronts montants de clkout_B.

La disposition en série et le fonctionnement des cellules retard τ dans chacun des canaux A, B, C est illustrée de manière générale par les figures 6 et 7. Sur chaque canal A, B, C, chacune des cellules retard τ est associée localement à un bloc de calcul logique qui ré-échantillonne une donnée de commande de retard de canal delin/delout, codée sur n+1 bits et fournie par le bloc de calcul logique précédent sur le canal correspondant.

Le rééchantillonnage est mis en oeuvre par le biais du signal d'horloge local clkout, l'horloge d'entrée clkin ayant été retardé par la cellule retard τ à laquelle est associé le bloc de calcul logique, ce qui garantit que la donnée de commande de retard de cellule del, codé sur p+1 bits (p pouvant être différent de n, et par exemple inférieur à n), est mise à jour après qu'un front d'horloge a été retardé, le respect du temps de prépositionnement de la commande de retard étant ainsi assuré.

La durée de l'opération d'échantillonnage mise en œuvre par un bloc de calcul logique est nécessairement inférieure au retard minimum pouvant être appliquée par chacune des cellules retard τ du canal, afin que la donnée de commande de retard de canal fournie par le bloc de calcul logique précédent sur le canal puisse être échantillonée par le signal d'horloge locale clkout retardé par la cellule retard τ.

Le rééchantillonnage de delin implique notamment que chaque cellule retard τ d'un même canal reçoive une donnée de commande de retard de cellule del distincte de celles que reçoivent les autres cellules retard τ du canal.

Cela permet d'augmenter la fréquence maximale du signal d'horloge de canal clkin, car le retard maximum pouvant être appliqué par la série de cellules retard sur un même canal n'est plus une contrainte agissant sur ladite fréquence.

Le principe de de la logique de la figure 7 consiste à réaliser la division entière du signal delin par le nombre de cellules retard τ que comprend le canal concerné. Cette division entière est en particulier très simple à mettre en oeuvre lorsque le nombre de cellules retard τ comprises sur le canal est une puissance de 2. Cette opération revient alors à faire un décalage vers la droite des bits du signal delin. Le nombre de décalages devient n-p quand le nombre de cellule est R = 2^{(n-p)}.

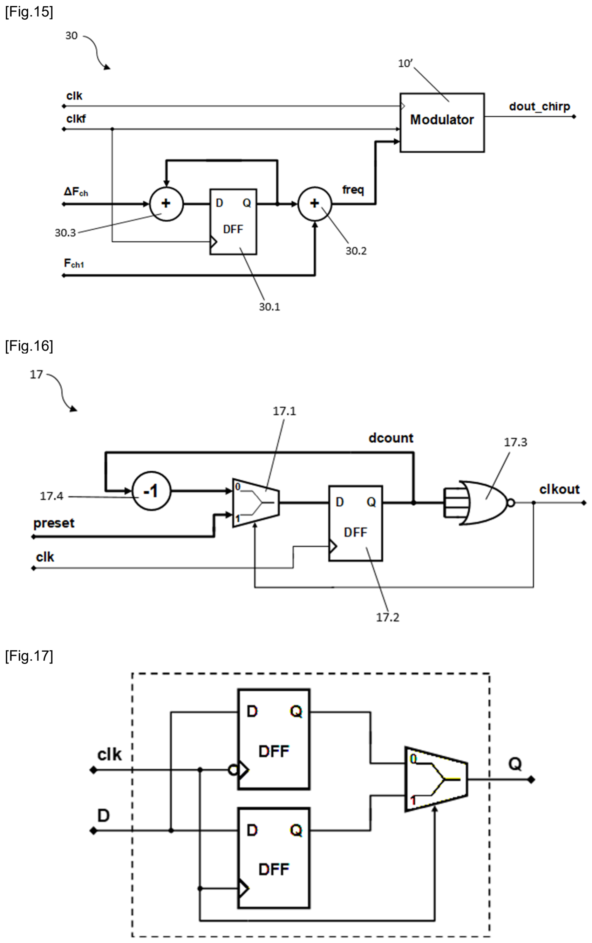

La figure 7 décrit plus en détails l'association d'une cellule retard τ et du bloc de calcul logique auquel elle est associée. Le signal delin est ré-échantillonné sur les deux fronts de l'horloge clkout, au moyen de bascules D telles que représentées à la figure 17.

La division entière est réalisée simplement en séparant les p+1 bits de poids forts, qui contiennent le résultat de la division entière, des n-p bits de poids faibles, qui contiennent le reste de la division, de la valeur numérique de delin échantillonné. Une porte logique OU appliquée sur ces bits permet de détecter que le reste de la division n'est pas nul. Dans ce cas, le résultat de la division est incrémenté de 1 pour fournir la valeur del à la cellule retard τ correspondante. Egalement si le reste de la division entière n'est pas nul, la valeur fournie à la cellule retard suivante sur le signal delout est décrémentée de 1. Avec ce mécanisme, les différentes valeurs de retard déterminées par le circuit logique d'entrée 11 sont réparties sur l'ensemble des cellules retard τ d'un même canal.

Pour pouvoir réaliser une modulation de fréquence autour de la fréquence porteuse F_{c}, il est nécessaire que le nombre R de cellules retard τ par canal A, B, C vérifie : $R > \frac{1}{{F}_{clk} \left({T}_{dmax}-{T}_{dmin}\right)}$

Avec T_{dmin} le retard minimum appliqué par chaque cellule retard τ, T_{dmax} le retard maximum appliqué par chaque cellule retard τ, et F_{clk} = 2.F_{c}.

Par exemple, le nombre de cellules retard τ par canal doit être supérieur à 4 si F_{clk} = 3,6GHz et que la différence entre le retard maximum et le retard minimum appliqués par chaque cellule retard τ est de 70ps.

Le modulateur 10 est notamment apte à mettre en œuvre une modulation d'une fréquence fᵢ, échantillonnée à la fréquence F_{f} du signal d'horloge d'échantillonnage clkf, sur la fréquence porteuse F_{c}, afin de générer en sortie un signal modulé en fréquence. Pour que le modulateur 10 fonctionne correctement en modulation de fréquence, la valeur absolue de fᵢ doit rester inférieure à F_{c}/2.

Un exemple d'un tel signal modulé dout est représenté sur le chronogramme de la figure 8c, pour lequel F_{f} = F_{c} et fᵢ = -F_{c}/6.

Pour la fréquence fᵢ échantillonnée par le signal d'horloge d'échantillonnage clkf, la phase vaut de manière générale : ${φ}_{i} = {φ}_{i - 1} - 2 π . {T}_{f} . {f}_{i}$

Un saut de phase d'un échantillon à l'autre devant être accumulé pour fournir la phase modulée vaut : $Δφ = {φ}_{i} - {φ}_{i - 1} = - 2 π . {T}_{f} . {f}_{i}$

Soit dans l'exemple de la figure 8c, les sauts de phase valent, dans le domaine temporel (avec T_{f} = T_{c} pour rappel) : Δφ = π/3.

Les sauts de phase n'étant effectivement appliqués qu'aux instants des fronts montants/descendants du signal modulé généré en sortie du modulateur dout, il est nécessaire de réaliser une correction des sauts de phase en passant du domaine temporel au domaine fréquentiel du signal modulé dout de fréquence Fₒᵤₜ = F_{c} + fᵢ = 1/Tₒᵤₜ: $φ {′}_{i} = φ {′}_{i - 1} - 2 π . {T}_{out} . {f}_{i}$

Par interpolation linéaire de la phase entre les fronts d'horloge, les sauts de phase valent donc, dans le domaine fréquentiel du signal modulé dout : $Δφ ′ = \frac{2 π . {T}_{c} . Δφ}{2 π . {T}_{f} - {T}_{c} . Δφ}$

Soit, dans l'exemple de la figure 8c pour lequel la fréquence modulée théorique vaut Fₒᵤₜ = F_{c} - F_{c}/6 = 5F_{c}/6 (et la période de dout : Tₒᵤₜ = 6T_{c}/5), les sauts de phase valent Δφ' = 2π/5.

En comparant le signal modulé représenté sur la figure 8c avec ceux représentés en figures 3a et 3b, il est manifeste que le modulateur 10 de l'invention n'introduit pas d'erreurs sur la fréquence du signal modulé dout qui correspond sur la figure 8c au signal modulé qui serait obtenu sans échantillonnage de phase. Ainsi, le modulateur 10 ne présente pas les inconvénients des modulateurs existants, et permet de moduler en phase ou en fréquence de manière cohérente.

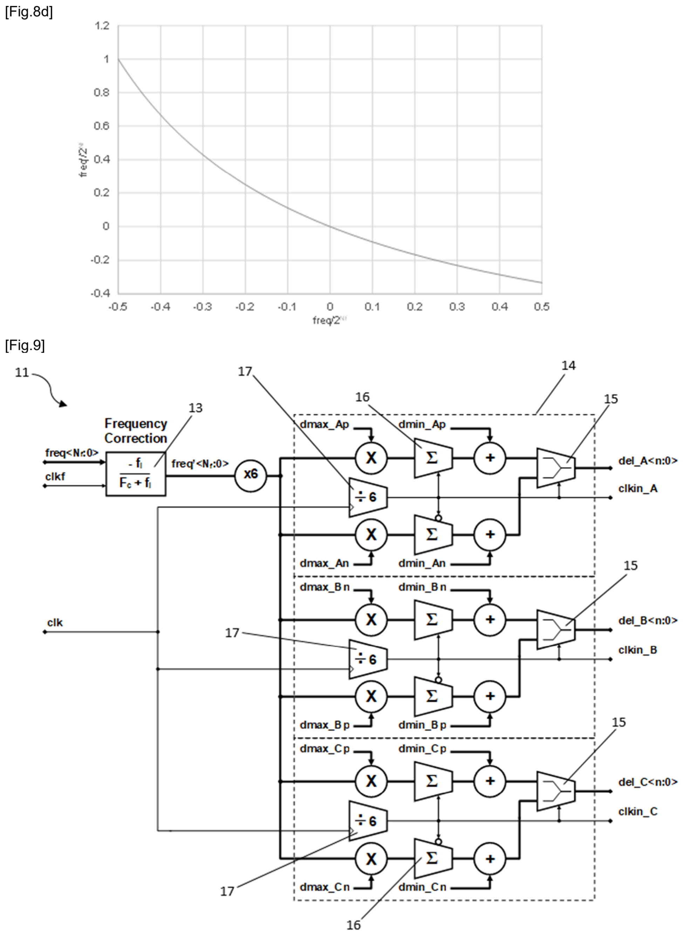

Le circuit logique d'entrée 11, représenté plus en détails à la figure 9, comprend un circuit de correction de fréquence 13 (correcteur de fréquence) fonctionnant au rythme du signal d'horloge d'échantillonnage clkf (pouvant être indépendant du signal d'horloge maître clk). C'est-à-dire que les échantillons de fréquence freq, sont fournis au circuit logique d'entrée 11 au rythme du signal d'horloge d'échantillonnage clkf de fréquence F_{f} inférieure à la fréquence porteuse F_{c} du modulateur.

Ce circuit de correction de fréquence 13 produit des échantillons de variation de phase sur freq' à partir des échantillons de fréquence normalisés sur l'entrée freq, la normalisation des échantillons de fréquence, à réaliser par l'utilisateur du modulateur 10, consistant à transformer les échantillons de fréquence fᵢ en valeurs binaires sur freq tel que freq = (fᵢ/F_{c})*2^{Nf} et N_{f}+1 le nombre de bits de freq.

Par analogie avec le calcul des sauts de phase dans le domaine fréquentiel du signal modulé dout présenté ci-dessous, on a : $freq ′ = \frac{Δφ . {T}_{c} {.2}^{{N}_{f}}}{2 π . {T}_{f} - {T}_{c} . Δφ}$

Avec, comme vu précédemment, Δφ = -2π.T_{f}.fᵢ., soit en simplifiant : $freq ′ = \frac{- {f}_{i} {.2}^{{N}_{f}}}{{f}_{i} + {F}_{c}}$

Ou encore en fonction de l'entrée numérique freq : $freq ′ = \frac{- freq {.2}^{{N}_{f}}}{freq + {2}^{{N}_{f}}}$

La figure 8d représente la fonction de correction de fréquence normalisée mise en œuvre par le circuit de correction de fréquence 13.

Le circuit logique d'entrée 11 comprend également un circuit de calcul 14 divisé en trois canaux de calcul identiques entre eux :
- le premier canal de calcul génère en sortie le signal d'horloge de canal clkin_A et les données de commande de retard de canal del_A.
- le deuxième canal de calcul génère en sortie le signal d'horloge de canal clkin_B et les données de commande de retard de canal del_B.
- le troisième canal de calcul génère en sortie le signal d'horloge de canal clkin_C et les données de commande de retard de canal del_C.

Chaque canal de calcul est en outre composé de deux sous-canaux dédiés respectivement aux calculs correspondant aux fronts montants et aux fronts descendants du signal d'horloge maître.

Ainsi et puisque le modulateur 10 comprend trois canaux A, B, C et que la fréquence F_{clk} = 2. F_{c}, les signaux d'horloge de canal clkin_A, clkin_B, clkin_C sont générés à partir du signal d'horloge maître clk par des diviseurs d'horloge 17 divisant ladite horloge par six.

Le schéma de principe d'un tel diviseur d'horloge 17 est fourni à la figure 16, qui représente en l'occurrence un décompteur numérique permettant de réaliser la division du signal d'horloge maître clk par un nombre entier fourni par la valeur numérique preset fourni sur l'une des entrées d'un multiplexeur 17.1. Un registre à bascules 17.2 qui fournit en sortie un signal binaire dcount à une porte logique NON-OU 17.3 (NOR en terminologie anglaise). Cette porte logique NON-OU 17.3 génère un signal de sortie clkout dont le niveau est à 1 quand tous les bits du signal dcount sont à 0, indiquant ainsi la fin d'un cycle de décomptage, et dont le niveau est à 0 le reste du temps. Le diviseur d'horloge 14 comprend aussi un soustracteur 17.4 appliquant une soustraction de 1 sur le signal dcount et le résultat de cette soustraction est fourni au multiplexeur 17.1, lequel est par ailleurs commandé par le signal clkout de telle façon que l'entrée du multiplexeur 17.1 recevant la valeur numérique preset est sélectionnée lorsque le signal clkout est au niveau 1. Le signal de sortie du multiplexeur 17.1 est échantillonné par le registre à bascule 17.2, ce qui fait que le signal dcount est décrémenté de 1 à chaque période du signal d'horloge maître clk tant que le niveau du signal clkout est à 0. Quand le niveau du signal clkout passe à 1, le registre à bascule 17.2 est préchargé avec la valeur numérique preset et un nouveau cycle de décomptage démarre.

Une fois le signal d'horloge maître clk divisé par six, chaque signal d'horloge de canal clkin_A, clkin_B, clkin_C présente un niveau logique permettant de réaliser, grâce à un multiplexeur 15 et en fonction des valeurs des fronts montants ou des fronts descendants, une sélection des données de commande de retard de canal del_A, del_B, del_C.

Une valeur retard est calculée à partir de freq' en multipliant freq' par 6 ainsi que par dmax_y (y = An, Ap, Bn, Bp, Cn, Cp) puis en réalisant une accumulation au moyen d'un accumulateur 16. La multiplication par 6 est due au fait que l'accumulation des échantillons est réalisée à la fréquence de clkin_x (x = A, B, C) c'est-à-dire 6 fois plus lentement que la fréquence porteuse F_{c}.

La valeur de dmax_y est obtenue par la calibration des canaux retard qui sera expliquée plus en avant. Cette valeur de dmax_y correspond au retard égal à une période du signal d'horloge maître clk, et correspond également à une phase de π de la porteuse F_{c} car la période du signal d'horloge maître *clk* équivaut ici à T_{c}/2.

En sortie de l'accumulateur 16, le résultat est additionné à dmin_y (y = An, Ap, Bn, Bp, Cn, Cp) qui est également obtenu lors de la calibration. La valeur de dmin_y correspond au retard à l'origine c'est-à-dire à une phase de 0. L'accumulateur 16 réalise la même fonction que l'intégrale mathématique qui permet de calculer la phase à partir d'une fréquence. Ce calcul est réalisé ici en temps discret ce que permet la normalisation de freq par rapport à F_{c}. Il est à noter que le nombre de bits n+1 des sorties del_x (x = A, B, C) peut être plus faible que le nombre de bits N_{f}+1 de freq, et ce sans dégrader la précision de la modulation.

L'accumulateur 16 réalisant en fait une accumulation de phase, il est nécessaire de tenir compte du modulo, en l'occurrence d'un modulo π représenté par la valeur de dmax_y (y=An, Ap, Bn, Bp, Cn, Cp) dans le cas du modulateur 10, ladite valeur de dmax_y étant prévu pour produire un retard correspondant à T_{c}/2, c'est-à-dire à une période du signal d'horloge maître clk du modulateur 10.

Pour tenir compte du modulo, il est nécessaire de soustraire dmax_y quand la sortie de l'accumulateur 16 atteint ou dépasse dmax_y. Plus généralement, il est par ailleurs nécessaire d'ajouter autant de fronts d'horloge que de modulos ainsi soustraits.

Inversement, il faut ajouter dmax_y quand la sortie de l'accumulateur 16 atteint des valeurs négatives, et il faut dans ce cas supprimer autant de fronts d'horloge que de modulos ainsi ajoutés.

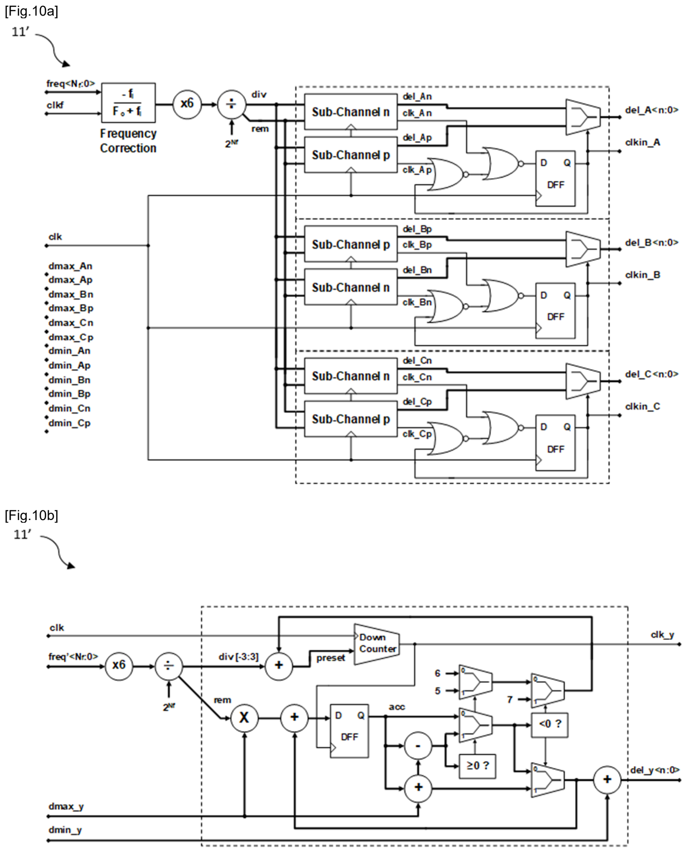

La figure 10a représente un exemple de réalisation du circuit logique d'entrée 11' avec prise en compte du modulo.

Précisément, chacun des sous-canaux de chaque canal de calcul du circuit logique d'entrée 11 doit donc permettre une prise en compte du modulo lors de la génération du signal d'horloge de sous-canal clk_y et de la donnée de commande de retard de sous-canal del_y.

La structure et le fonctionnement d'un de ces sous-canaux est représenté à la figure 10b, lequel permet de compter le nombre de modulos nécessaires, et ajuste ainsi le nombre de périodes du signal d'horloge maître clk entre deux fronts du signal d'horloge de sous-canal clk_y qu'il génère.

Afin d'ajouter ou supprimer des fronts lors des modulos, un décompteur génère une impulsion d'une période du signal d'horloge maître *clk* sur la sortie *clk_y* et charge une nouvelle valeur fournie sur preset lorsqu'il atteint 0. En l'absence de modulo, la valeur de preset vaut 6 et le décompteur se comporte comme un diviseur d'horloge par 6. La valeur de preset est la somme de deux composantes.

Une première composante de preset est issue de freq' multiplié par 6 et divisé par 2^{Nf} (décalage de N_{f} bits vers la droite), le résultat de cette division entière signée représentant le nombre de modulos contenus dans 6 fois freq' (cette valeur étant comprise entre -3 et 3 dans le cas du modulateur 10). Le reste de cette division entière est multiplié par dmax_y pour réaliser la conversion vers un incrément de retard calibré.

L'autre composante de preset est issue de la détection des modulos suite à l'opération d'accumulation et vaut 6 hors modulo.

L'accumulateur est formé d'un additionneur et d'un registre dont l'horloge est le signal clk_y. La fréquence du signal clk_y est autour de 6 fois plus basse que celle du signal d'horloge maître clk, ce qui donne plus de temps aux calculs de l'accumulateur pour pouvoir se faire.

Les modulos sont détectés en comparant la sortie de l'accumulateur acc à la valeur de dmax_y. Quand la sortie de l'accumulateur acc atteint dmax_y, un sélecteur prend le résultat de accdmax_y, de plus la composante de preset passe à 5 et le prochain front de clk_y sera plus proche d'une période de clk. Quand la sortie de l'accumulateur acc devient négative, un autre sélecteur prend le résultat de acc+dmax_y et la composante de preset passe à 7, le prochain front de clk_y sera éloigné d'une période de clk. Grâce à la correction du modulo, la valeur de retard est assurée d'être comprise entre 0 et dmax_y à laquelle est ajouté dmin_y pour fournir del_y.

Ainsi, le fonctionnement du circuit logique d'entrée 11' tenant compte du modulo peut être expliqué en se référant par exemple au canal A (le fonctionnement pour le canal C étant identique, le fonctionnement pour le canal B étant similaire avec inversion du rôle de sous-canaux n et p). Chaque canal se compose de deux sous-canaux n et p pour le calcul et la génération des signaux d'horloge de canal respectivement des fronts montants et descendants de dout.

Lorsque le sous-canal n génère une impulsion d'horloge sur clk_An, grâce à une porte NON-OU (« NOR » en terminologie anglaise), l'entrée D de la bascule D est forcée à 0. Cette bascule est cadencée par le signal d'horloge maître clk. Sur un front montant du signal d'horloge maître clk, la sortie Q passe à 0 ce qui génère un front descendant sur le signal d'horloge de canal clkin_A. Entre deux impulsions, le signal d'horloge de canal clkin_A est appliqué en retour sur l'entrée d'une deuxième porte NON-OU de façon à maintenir le niveau logique sur l'entrée D de la bascule D. Quand survient une impulsion sur clk_Ap, la sortie de cette deuxième porte NON-OU est forcée à 0. Comme l'horloge clk_An était redescendu à 0, la première porte NON-OU force à 1 l'entrée D de la bascule. Au front montant du signal d'horloge maître clk, un front montant est généré sur le signal d'horloge de canal clkin_A.

Un multiplexeur permet de sélectionner del_Ap quand le signal d'horloge de canal clkin_A est à 1, ou bien del_An quand clkin_A est à 0, et de fournir le résultat sur del_A. De cette façon par exemple, un front descendant du signal d'horloge de canal clkin_A pourra ré-échantillonner la valeur de del_Ap, qui est présent sur del_A dans la première cellule retard τ du canal A. La valeur de retard correspondant aux fronts montants sera ainsi pré-positionnée avant l'arrivée d'un front montant du signal d'horloge de canal clkin_A. Il se passe la réciproque pour les valeurs de retard des fronts descendants.

Le modulateur 10 repose sur l'utilisation de cellule retard τ telle que celles représentées aux figures 12a à 12c, qui sont en partie des dispositifs analogiques dont il est difficile de prévoir avec précision le retard qu'ils appliqueront en fonction de leurs signaux de commande, notamment à cause de dispersions dans leur processus de fabrication, de l'imprécision de leur tension d'alimentation électrique et de la température.

Il est donc nécessaire, avant d'utiliser le modulateur 10, d'effectuer une calibration des retards rééllement appliqués par les cellules retard τ du modulateur et donc par chacun des canaux du modulateur, d'autant plus que le résultat dépend également de la fréquence du signal d'horloge maître clk. La calibration a pour objectif d'ajuster le retard réellement appliqué à un déphasage souhaité.

La figure 4 démontre en outre qu'il est nécessaire de réaliser une calibration des cellules retard τ pour les fronts montants et une calibration pour les fronts descendants.

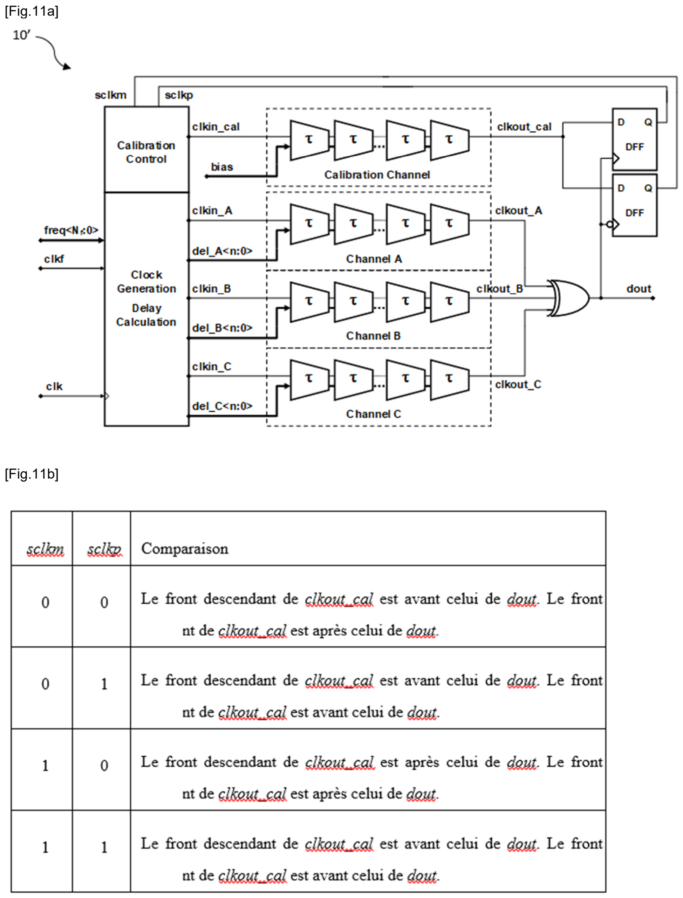

La figure 11a représente donc un modulateur 10' conforme à un deuxième mode de réalisation de l'invention, qui présente la particularité, par rapport au modulateur 10, de comprendre un canal de calibration cal spécifiquement dédié à la calibration du modulateur 10' en plus des canaux A, B, C.

Le procédé de calibration repose sur une mesure différentielle entre un des trois canaux A, B, C et le canal de calibration cal, lequel est identique aux canaux A, B, C mais présente la particularité de recevoir une donnée de commande de retard de canal fixe bias, laquelle est réglée de manière à être légèrement supérieure à 0 afin qu'aucun des autres canaux A, B, C ne risque d'être saturé à 0 lors de la calibration.

La calibration permet de mettre à jour les registres dmax_y et dmin_y avant d'utiliser le modulateur 10'. Tous les canaux et sous-canaux sont calibrés les uns après les autres. Pour calibrer un canal et un sous-canal donnés, les horloges clkout_x des autres canaux sont fixées aux valeurs logiques que présenteraient ces canaux pendant la modulation à l'instant du front considéré. Ainsi, au moment des fronts montants de clkout_A, les horloges clkout_B et clkout_C sont toujours à 0. Par contre au moment des fronts montants de clkout_B, clkout_A est à 1 tandis que clkout_C est à 0. Grâce à ce mécanisme, pendant la calibration, les temps de propagation des fronts jusqu'à la sortie dout sont bien représentatifs du fonctionnement normal en modulation.

Pour calibrer un front d'un canal, le bloc numérique produit une horloge fixe sur clkin_x issue de la division de clk. La calibration d'un front commence par la mesure de dmin_y, c'est-à-dire la valeur du retard à l'origine. Pour cela le contrôleur de la calibration génère sur clkin_cal la même horloge que celle sur clkin_x. Au démarrage, la valeur de del_x est initialisée à 0 et le but est que cette valeur augmente jusqu'à atteindre une valeur proche de bias. Pour cela un dispositif comparateur de phase, dont la table de vérité est représentée en figure 11b est disposé entre dout et la sortie du canal de calibration clkout_cal. Il s'agit de deux bascules D qui échantillonnent clkout_cal l'une sur les fronts montants, l'autre sur les fronts descendants de dout. Les niveaux logiques des deux signaux générés sclkm et sclkp permettent de déterminer si dout est en avance ou en retard par rapport à clkout_cal en fonction du front considéré.

Tant que dout est en avance sur clkout_cal, une erreur de phase positive est incrémentée, filtrée puis envoyée sur del_x. Réciproquement l'erreur est décrémentée quand dout est en retard sur clkout_cal. Quand les deux horloges sont en phase, cette boucle converge vers la bonne valeur de retard. Une fois que la convergence a atteint un certain seuil de précision, la valeur de del_x est placée dans le registre dmin_y et la calibration passe à l'étape suivante.

Pour la mesure de dmax_y, le contrôleur de calibration génère sur clkin_cal une horloge retardée d'une période de clk par rapport à celle présente sur clkin_x. Ensuite le processus se déroule de la même façon que pour dmin_y et del_x converge vers la valeur pour laquelle les horloges sont en phase. Comme clkin_cal a été retardée d'une période de clk, dans cette implémentation cela correspond à un déphasage de π par rapport à la porteuse F_{c}. Après convergence, la valeur del_x-dmin_y est placée dans le registre dmax_y.

Comme toutes les étapes de calibration sont réalisées par comparaison avec un unique canal de calibration dont le réglage bias reste inchangé, tous les canaux sont calibrés sur une même référence et sont tous calibrés les par rapport aux autres.

L'invention décrite ci-dessus trouve avantageusement une application dans le cadre de la synthèse de fréquence dite « chirp » qui présente la particularité de produire un spectre de forme rectangulaire dans le domaine fréquentiel, et pour laquelle le signal temporel connait une variation de fréquence continue et linéaire avec le temps entre une première fréquence F_{ch1} (dite fréquence de démarrage) et une deuxième fréquence F_{ch2} (dite fréquence finale) sur une certaine période de temps T_{ch}.

En observant la figure 14, qui représente dans le domaine temporel un signal généré un synthétiseur de fréquence dit « chirp » avec F_{ch1} = 100 MHz, F_{ch2} = 2 GHz et T_{ch} = 100ns, on comprend que la principale difficulté que soulève la modulation « chirp » pour les synthétiseurs de fréquence existants est de devoir générer une variation de fréquence importante en très peu de temps (19 GHz / µs).

Or, l'utilisation du modulateur de l'invention dans un synthétiseur 30 de fréquence dit « chirp » tel que représenté à la figure 15 permet de générer en sortie de manière fiable et simple un signal dout_chirp similaire au signal représenté à la figure 14. Pour cela, le synthétiseur 30 comprend notamment un registre à bascule 30.1 cadencé par le signal d'horloge d'échantillonnage clkf, et génère des échantillons de fréquence freq calculés au rythme du signal d'horloge d'échantillonnage clkf à partir de la valeur de la fréquence de démarrage F_{ch1}, laquelle est ajouté au signal de sortie du registre à bascule 30.1 au moyen d'un premier additionneur 30.2, et de la valeur de la pente de variation fréquentielle ΔF_{ch} = (F_{ch2}-F_{ch1})/T_{ch}, ΔF_{ch} étant ajouté au signal de sortie du registre à bascule 30.1 au moyen d'un deuxième additionneur 30.3 et envoyé en entrée du registre à bascule 30.1.

L'invention ne se limite évidemment pas au mode de réalisation décrit en détails ci-dessus, et englobe toutes les variantes de réalisation à la portée de l'homme du métier. Par exemple, les différents messages échangés entre les dispositifs électroniques (capteurs et actionneurs) et l'unité de commande peuvent présenter des structures et/ou des durées de transmission distinctes à celles définies ci-dessus.

## Revendications

1. Modulateur (10, 10') comprenant :
- Au moins deux canaux (A, B, C) disposés en parallèle, chaque canal (A, B, C) recevant respectivement en entrée un signal d'horloge de canal (clkin_A, clkin_B, clkin_C), chaque canal (A, B, C) étant apte à retarder les fronts montants et/ou descendants du signal d'horloge de canal (clkin_A, clkin_B, clkin_C) afin de générer un signal de canal modulé (clkout_A, clkout_B, clkout_C) en fonction de données de commande de retard de canal (del_A, del_B, del_C) respectivement ;
- Un circuit logique d'entrée (11, 11') recevant en entrée un signal d'horloge maître (clk) de fréquence F_{clk} ainsi que des échantillons de fréquence normalisés (freq), et apte à générer les signaux d'horloge de canal (clkin_A, clkin_B, clkin_C) à partir du signal d'horloge maître (clk), et générer les données de commande de retard de canal (del_A, del_B, del_C) en fonction des échantillons de fréquence normalisés (freq) ;
- Un circuit logique de sortie (12) recevant en entrée chaque signal de canal modulé (clkout_A, clkout_B, clkout_C) et apte à générer un signal de sortie modulé en fréquence (dout) issu de la combinaison des signaux de canal modulés (clkout_A, clkout_B, clkout_C).

2. Modulateur (10, 10') selon la revendication 1, dans lequel le nombre de canaux (A, B, C) est impair.

3. Modulateur (10, 10') selon la revendication 1 ou la revendication 2, dans lequel le circuit logique de sortie (12) comprend une porte logique « ou exclusif ».

4. Modulateur (10, 10') selon l'une des revendications précédentes, dans lequel chaque canal (A, B, C) comprend au moins deux cellules retard (τ) identiques montées en série et aptes à retarder les fronts montants et/ou descendants du signal d'horloge de canal (clkin_A, clkin_B, clkin_C) en fonction de données de commande de retard de cellule (del).

5. Modulateur (10, 10') selon la revendication 4, dans lequel le nombre R de cellules retard (τ) par canal (A, B, C) est une puissance de 2.

6. Modulateur (10, 10') selon la revendication 4 ou la revendication 5, dans lequel le nombre R de cellules retard (τ) par canal (A, B, C) vérifie : $R > \frac{1}{{F}_{clk} \left({T}_{dmax}-{T}_{dmin}\right)}$, où T_{dmin} et T_{dmax} sont respectivement le retard minimum et le retard maximum applicable par chacune des cellules retard (τ).

7. Modulateur (10, 10') selon l'une des revendications 4 à 6, dans lequel chaque cellule retard (τ) d'un même canal (A, B, C) est associé à un unique bloc de calcul numérique apte à générer la donnée de commande de retard de cellule (del) destinée à la cellule retard (τ) à laquelle il est associé en fonction des données de commande de retard de canal (del_A, del_B, del_C).

8. Modulateur (10, 10') selon l'une des revendications précédentes, dans lequel le circuit logique d'entrée (11, 11') comprend un circuit de correction de fréquence (13) apte à mettre en œuvre une fonction de correction des échantillons de fréquence normalisés (freq) de manière à obtenir des échantillons fréquence corrigés (freq') telle que : $freq ′ = \frac{- freq {.2}^{{N}_{f}}}{freq + {2}^{{N}_{f}}}$.

9. Modulateur (10, 10') selon l'une des revendications précédentes, dans lequel le circuit logique d'entrée (11, 11') comprend autant de canaux de calcul que de canaux (A, B, C) compris par le modulateur (10, 10'), chaque canal de calcul étant associé à un desdits canaux (A, B, C) et générant le signal d'horloge de canal (clkin_A, clkin_B, clkin_C) et la donnée de commande de retard de canal (del_A, del_B, del_C) destinés au canal (A, B, C) lui étant associé.

10. Modulateur (10, 10') selon la revendication 9, dans lequel chaque canal de calcul comprend un premier sous-canal dédié au calcul du retard appliqué aux fronts montants du signal d'horloge maître (clk) et un deuxième sous-canal dédié au calcul du retard appliqué aux fronts descendants du signal d'horloge maître (clk).

11. Modulateur (10') selon l'une des revendications précédentes, comprenant en outre un canal de calibration (cal).

12. Procédé de modulation polaire de fréquence mis en œuvre par le modulateur (10, 10') selon l'une des revendications précédentes, le procédé comprenant :
- Une étape de génération, par le circuit logique d'entrée (11, 11') du modulateur (10, 10'), de signaux d'horloge de canal (clkin_A, clkin_B, clkin_C) à partir d'un signal d'horloge maître (clk) de fréquence F_{clk} reçu en entrée du circuit logique d'entrée (11, 11') du modulateur (10, 10') ;
- Une étape de génération des données de commande de retard de canal (del_A, del_B, del_C), par le circuit logique d'entrée (11, 11') du modulateur (10, 10'), en fonction des échantillons de fréquence normalisés (freq) reçus en entrée du circuit logique d'entrée (11, 11') du modulateur (10, 10') ;
- Une étape de génération des signaux de canal modulé (clkout_A, clkout_B, clkout_C) à partir des signaux d'horloge de canal (clkin_A, clkin_B, clkin_C) et en fonction des données de commande de retard de canal (del_A, del_B, del_C) ;
- Une étape de génération du signal de sortie modulé (dout), par le circuit logique de sortie (12) du modulateur (10, 10'), en combinant les signaux de canal modulés (clkout_A, clkout_B, clkout_C).
